# FASCICULE DE BREVET EUROPEEN

(11) **EP 3 171 415 B1**
(45) Date de publication et mention de la délivrance du brevet: **20.03.2019**
(21) Numéro de dépôt: 16197403.5
(22) Date de dépôt: 04.11.2016
(51) Int. Cl.: H01L 33/50

(54) **PROCÉDÉ DE FABRICATION D'UNE COUCHE CONTENANT DES BOÎTES QUANTIQUES**
HERSTELLUNGSVERFAHREN EINER SCHICHT DIE QUANTENPUNKTE ENTHÄLT
METHOD FOR PRODUCING A LAYER CONTAINING QUANTUM DOTS

(30) Priorité: 17.11.2015 FR 1561047
(43) Date de publication de la demande: 24.05.2017
(73) Titulaire: COMMISSARIAT À L'ÉNERGIE ATOMIQUE ET AUX ÉNERGIES ALTERNATIVES, 75015 Paris (FR)
(72) Inventeur: SANCHOT, Audrey, 31770 COLOMIERS (FR); AVENTURIER, Bernard, 38134 SAINT JOSEPH DE RIVIERE (FR)
(74) Mandataire: Cabinet Beaumont

(56) Documents cités:
- WO-A1-2015/135839
- JP-A- 2003 298 120
- US-A1- 2010 059 771
- US-A1- 2013 011 635
- US-A1- 2014 014 988
- ZHIYUAN TIAN ET AL: "Photoswitchable Fluorescent Nanoparticles: Preparation, Properties and Applications", CHEMPHYSCHEM, vol. 10, no. 15, 19 October 2009 (2009-10-19), pages 2577-2591, XP055165511, ISSN: 1439-4235, DOI: 10.1002/cphc.200900492

## Description

### Domaine

La présente demande concerne un procédé de fabrication d'une couche contenant des boîtes quantiques, cette couche comportant des premières régions dans lesquelles les boîtes quantiques sont actives, et des deuxièmes régions dans lesquelles les boîtes quantiques sont inactives.

### Exposé de l'art antérieur

On appelle boîte quantique ("quantum dot" en anglais) une nanoparticule semiconductrice tridimensionnelle de structure cristalline, présentant des propriétés de confinement quantique dans les trois dimensions de l'espace. Les boites quantiques présentent des propriétés physiques, notamment des propriétés magnétiques, des propriétés électriques, et des propriétés optiques, qui varient en fonction de leurs dimensions et en fonction des matériaux les constituant. Les dimensions d'une boîte quantique sont typiquement comprises entre 1 et 100 nm.

Les boîtes quantiques ont notamment pour propriété d'être photoluminescentes, c'est-à-dire que, lorsqu'elles sont éclairées par une source lumineuse, elles absorbent des photons en provenance de la source lumineuse, puis réémettent de la lumière en réponse à cette photoexcitation. Alors que la bande de longueurs d'ondes d'absorption, c'est-à-dire la bande de longueurs d'ondes d'éclairement dans laquelle une boîte quantique absorbe des photons, peut être relativement large, la bande de longueur d'ondes d'émission, c'est-à-dire la bande de longueurs d'ondes dans laquelle la boîte quantique réémet de la lumière, est généralement très étroite, par exemple de largeur à mi-hauteur inférieure à 50 nm. De plus, la longueur d'onde centrale de la bande d'émission peut être ajustée finement en jouant notamment sur les dimensions de la boîte quantique.

L'une des applications des boîtes quantiques dans le domaine de l'optique est la conversion de couleurs. Il a notamment été proposé de réaliser un écran d'affichage lumineux comportant une pluralité de diodes électroluminescentes adaptées à émettre de la lumière d'une première couleur, par exemple de la lumière bleue, cet ensemble de diodes étant revêtu d'une couche comportant des boîtes quantiques pour convertir en une ou plusieurs autres couleurs, par exemple en lumière rouge dans certaines régions de l'écran et en lumière verte dans d'autres régions de l'écran, la lumière émise par les diodes électroluminescentes.

La réalisation d'un tel écran pose toutefois des difficultés pratiques, liées notamment aux propriétés que doit présenter la couche de boîtes quantiques, et en particulier son épaisseur et sa concentration en boîtes quantiques, pour pouvoir absorber la totalité ou la quasi-totalité de la lumière émise par les diodes électroluminescentes dans les zones de l'écran dans lesquelles on souhaite convertir cette lumière. Une autre difficulté est qu'il faut pouvoir définir avec une résolution adaptée à la taille des pixels ou zones émettrices de l'écran les différentes régions d'émission de la couche de boîtes quantiques.

Le document US2010/059771 décrit un multicouches de photophores pour diodes électroluminescentes. Le document US2014/014988 décrit un dispositif d'éclairage comportant des composants optiques à motifs. Le document WO2015/135839 décrit un élément de conversion de longueur d'onde, un dispositif d'émission lumineuse comprenant un tel élément, une méthode de fabrication d'un tel élément, et une méthode de fabrication d'un dispositif d'émission lumineuse comportant un tel élément. Le document US2013/011635 décrit des nanocristaux semiconducteurs photosensibles, une composition photosensible comportant de tels nanocristaux, et une méthode pour former un motif de nanocristaux semiconducteurs. L'article intitulé "Photoswitchable Fluorescent Nanoparticles: Préparation, Properties and Applications" de Zhiyuan Tian et al. (ChemPhysChem 2009, 10, 2577-2591) décrit des nanoparticules fluorescentes photo-commutables, leur préparation, leurs propriétés et leurs applications.

### Résumé

Ainsi, un mode de réalisation prévoit un procédé de fabrication d'une couche contenant des boîtes quantiques, cette couche comportant des premières régions dans lesquelles les boîtes quantiques sont actives, et des deuxièmes régions dans lesquelles les boîtes quantiques sont inactives, ce procédé comportant les étapes suivantes : a) déposer sur un support une première couche d'une matrice dans laquelle sont incorporées des boîtes quantiques ; b) déposer sur la première couche une deuxième couche de résine photosensible ; c) insoler la deuxième couche au travers d'un masque délimitant, en vue de dessus, les premières et deuxièmes régions, puis développer la résine de la deuxième couche de façon à retirer la résine de la deuxième couche en regard des deuxièmes régions, et à conserver la résine de la deuxième couche en regard des premières régions ; et d) retirer la résine de la deuxième couche en regard des premières régions sans retirer la matrice de la première couche en regard des premières et deuxièmes régions.

Selon un mode de réalisation, la matrice de la première couche est une résine photosensible.

Selon un mode de réalisation, la résine photosensible de la première couche est choisie parmi l'une des familles de l'ensemble comportant la famille des résines photosensibles positives et la famille des résines photosensibles négatives, et dans lequel la résine photosensible de la deuxième couche est choisie parmi l'autre famille dudit ensemble.

Selon un mode de réalisation, la matrice de la première couche est une résine photosensible négative et la résine de la deuxième couche est une résine photosensible positive.

Selon un mode de réalisation, la matrice de la première couche est une résine photosensible de type SU8, et la résine de la deuxième couche est une résine de type TELR.

Selon un mode de réalisation, le procédé ne comporte pas d'étape d'insolation de la matrice de la première couche avant le dépôt de la deuxième couche.

Selon un mode de réalisation, l'étape de développement de la résine de la deuxième couche comprend le trempage de la deuxième couche dans une solution à base de TMAH.

Selon un mode de réalisation, les boîtes quantiques incorporées dans la matrice de la première couche sont des boîtes quantiques de type CdSe/ZnS.

Selon un mode de réalisation, lors de l'étape d), la résine de la deuxième couche est retirée par gravure plasma à l'oxygène.

Selon un mode de réalisation, le procédé comporte en outre, après l'étape d), une étape de gravure d'une portion superficielle supérieure de la première couche.

Selon un mode de réalisation, l'étape de gravure d'une portion superficielle supérieure de la première couche est réalisée par gravure plasma à l'oxygène et à l'hexafluorure de soufre.

Selon un mode de réalisation, les étapes a), b), c) et d) sont répétées une deuxième fois pour former, sur la première couche, une troisième couche contenant des boîtes quantiques, cette troisième couche comportant des premières régions dans lesquelles les boîtes quantiques sont actives, et des deuxièmes régions dans lesquelles les boîtes quantiques sont inactives.

Selon un mode de réalisation, les premières régions de la troisième couche sont disposées en regard de deuxièmes régions de la première couche, et des deuxièmes régions de la troisième couche sont disposées en regard de premières régions de la première couche.

Un autre mode de réalisation prévoit un dispositif comportant une source de lumière et, en regard de la source de lumière, une couche contenant des boîtes quantiques réalisée par un procédé du type susmentionné.

Un autre mode de réalisation prévoit un dispositif comportant une source de lumière et, en regard de la source de lumière, un empilement d'une première couche contenant des boîtes quantiques et d'une deuxième couche contenant des boîtes quantiques, réalisé par un procédé du type susmentionné.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
les figures 1A, 1B, 1C, et 1D sont des vues en coupe illustrant de façon schématique des étapes d'un exemple d'un mode de réalisation d'un procédé de fabrication d'une couche contenant des boîtes quantiques, cette couche comportant des premières régions dans lesquelles les boîtes quantiques sont actives, et des deuxièmes régions dans lesquelles les boîtes quantiques sont inactives ; et
la figure 2 est une vue en coupe illustrant de façon schématique une variante de réalisation du procédé décrit en relation avec les figures 1A à 1D.

### Description détaillée

De mêmes éléments ont été désignés par de mêmes références aux différentes figures et, de plus, les diverses figures ne sont pas tracées à l'échelle. Dans la description qui suit, lorsque l'on fait référence à des qualificatifs de position tels que les termes "dessus", "dessous", "supérieur", "inférieur", etc., il est fait référence à l'orientation des figures, étant entendu que, dans la pratique, les structures décrites peuvent être orientées différemment. Sauf précision contraire, les expressions, "sensiblement", "quasiment", "environ" et "de l'ordre de" signifient à 10 % près, de préférence à 5 % près.

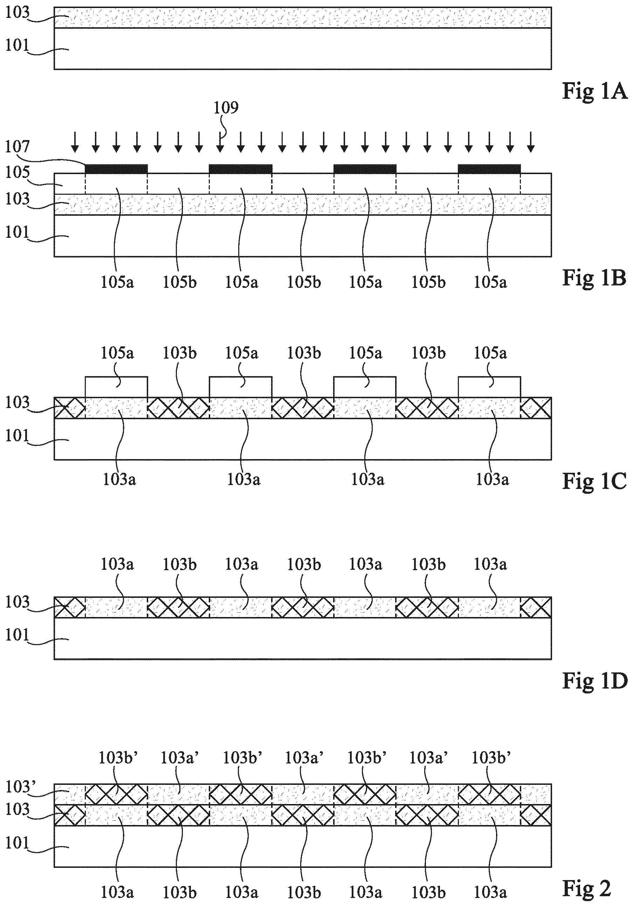

La figure 1A illustre une étape de dépôt, sur la face supérieure d'un substrat de support 101, par exemple un substrat en silicium, d'une couche 103 comportant une matrice en une résine photosensible transparente dans laquelle sont incorporées des boîtes quantiques. Dans cet exemple, la résine photosensible de la couche 103 appartient à la famille des résines photosensibles négatives, c'est-à-dire les résines pour lesquelles les parties exposées à un rayonnement lumineux lors d'une étape d'insolation de la résine deviennent insolubles dans un révélateur appliqué sur la résine lors d'une étape ultérieure de développement, et pour lesquelles les parties non exposées au rayonnement lumineux sont solubles dans le révélateur. La résine photosensible de la couche 103 est par exemple une résine à base de polyépoxydes, par exemple une résine choisie parmi la famille des résines négatives de type SU8, c'est-à-dire dont la molécule élémentaire comprend huit groupements polyépoxydes. A titre d'exemple, la résine photosensible de la couche 103 est une résine du type désigné sous la dénomination commerciale SU8 1020PI par la société GERSELTEC ENGINEERING SOLUTIONS.

Les boîtes quantiques mélangées à la résine de la couche 103 sont par exemple des boîtes quantiques à base de séléniure de cadmium (CdSe), par exemple des boîtes quantiques à structure coeur-coquille de type CdSe/ZnS. A titre de variante, les boîtes quantiques de la couche 103 sont des boîtes quantiques à structure coeur-coquille de type InP/ZnS ou de type CdS/ZnS ou de type CdSe/ZnSe ou de type PbS/CdS.

A titre d'exemple, l'incorporation des boîtes quantiques dans la résine photosensible peut comprendre une étape de mélange des boîtes quantiques initialement sous forme de poudre dans un solvant, par exemple du chloroforme. La solution ainsi obtenue peut ensuite être mélangée à la résine. A titre d'exemple, les boîtes quantiques peuvent être mélangées dans le solvant à une concentration comprise entre 1 et 100 mg/ml, puis la solution obtenue peut être mélangée à la résine, par exemple selon un rapport de l'ordre de 2 pour 1 en volume (2 volumes de solution pour 1 volume de résine).

Préalablement au dépôt de la couche 103, la surface supérieure du substrat de support 101 peut être préparée, par exemple au moyen d'un plasma à l'oxygène, afin d'améliorer l'adhérence et/ou l'uniformité de la couche 103.

La couche de résine 103 peut être étalée sur la surface supérieure du substrat 101, par exemple par enduction centrifuge ("spin coating" en anglais). Un recuit de la structure, par exemple à une température comprise entre 80 et 150°C pendant une durée comprise entre 30 et 120 secondes, peut ensuite être réalisé pour durcir la couche de résine 103 afin de renforcer sa tenue mécanique.

A titre d'exemple, l'épaisseur de la couche 103 est comprise entre 0,5 et 50 µm, par exemple de l'ordre de 0,9 µm. A titre d'exemple illustratif, les calculs effectués par les inventeurs ont montré qu'une épaisseur de l'ordre de 1 µm permet d'absorber 99 % de la lumière bleue émise par une diode électroluminescente au nitrure de gallium pour un taux de remplissage en volume de la couche 103 de l'ordre de 50 %.

La figure 1B illustre une étape de dépôt, sur la face supérieure de la couche 103, d'une couche de résine photosensible 105. Dans cet exemple, la résine photosensible de la couche 105 appartient à la famille des résines photosensibles positives, c'est-à-dire les résines pour lesquelles les parties exposées à un rayonnement lumineux lors d'une étape d'insolation de la résine deviennent solubles dans un révélateur appliqué sur la résine lors d'une étape ultérieure de développement, et pour lesquelles les parties non exposées au rayonnement lumineux sont insolubles dans le révélateur. A titre d'exemple, la résine photosensible de la couche 105 est une résine de type désigné sous la dénomination commerciale TELR par la société TOK EUROPE. A la différence de la couche 103, la couche de résine 105 ne contient pas de boîtes quantiques. On notera en outre qu'il n'est pas prévu d'étape d'insolation de la couche 103, c'est-à-dire d'exposition de la couche 103 à un rayonnement lumineux susceptible de modifier sa structure, entre l'étape de formation de la couche 103 et l'étape de dépôt de la couche 105.

La couche de résine 105 peut être étalée sur la surface supérieure du substrat 101, par exemple par enduction centrifuge. Un recuit de la structure, par exemple à une température comprise entre 80 et 150°C pendant une durée comprise entre 30 et 120 secondes, peut ensuite être réalisé pour durcir la couche de résine 105 afin de renforcer sa tenue mécanique.

La figure 1B illustre en outre une étape postérieure au dépôt de la couche de résine 105, au cours de laquelle la couche 105 est insolée au travers d'un masque 107 disposé au-dessus de sa surface supérieure. Le masque 107 recouvre des premières régions 105a de la couche 105 et comporte des ouvertures en regard de deuxièmes régions 105b de la couche 105. Lors de l'étape d'insolation, la surface supérieure de l'assemblage est exposée à un rayonnement lumineux 109 apte à modifier la structure chimique de la résine de la couche 105 dans les régions de la couche 105 exposées à ce rayonnement. Le rayonnement appliqué pour insoler la résine de la couche 105 est par exemple un rayonnement violet ou ultraviolet, par exemple un rayonnement de longueur d'onde comprise entre 350 et 450 nm.

Après l'étape d'insolation, le masque 107 est retiré, et un recuit de stabilisation de la structure, par exemple à une température comprise entre 80 et 150°C pendant une durée comprise entre 30 et 120 secondes, peut être réalisé.

La figure 1C illustre une étape de développement de la couche de résine 105, postérieure à l'étape d'insolation décrite en relation avec la figure 1B. Lors de cette étape, l'assemblage formé par le substrat 101 et par les couches 103 et 105 est plongé dans un bain développeur adapté à révéler dans la couche de résine 105 le motif exposé à travers le masque 107 lors de l'étape d'insolation. Le bain développeur comprend par exemple une solution à base d'hydroxyde de tétraméthylammonium (TMAH), par exemple une solution désignée par la dénomination commerciale TMAH238 par la société MICROCHEMICALS. Lors de cette étape, les régions 105b de la couche de résine 105 préalablement exposées lors de l'étape d'insolation sont éliminées par dissolution dans le développeur. Ainsi, à l'issue de l'étape de développement, ne subsistent de la couche 105 que les régions 105a masquées pendant l'étape d'insolation.

A titre d'exemple, lors de l'étape de développement, la structure est trempée dans le bain développeur pendant 30 à 120 secondes jusqu'à obtenir des motifs nets dans la couche 105, puis rincée à l'eau et séchée.

De façon surprenante, les inventeurs ont constaté qu'à l'issue de l'étape de développement de la figure 1C, les boîtes quantiques contenues dans les régions 103b de la couche 103 au-dessus desquelles la résine de la couche 105 est entièrement retirée lors de l'étape de développement, sont inactives, alors que les boîtes quantiques contenues dans les régions 103a de la couche 103 au-dessus desquelles la résine de la couche 105 n'est pas retirée lors de l'étape de développement, sont restées actives. On entend ici par "inactives" que les boîtes quantiques contenues dans les régions 103b de la couche 103 ont perdu leurs propriétés photoluminescentes, et que les régions 103b de la couche 103 sont désormais sensiblement transparentes pour la lumière visible, c'est-à-dire qu'elles transmettent sans modifications significatives, notamment de couleur, la lumière qu'elles reçoivent. Par ailleurs, on entend ici par "actives" que les boîtes quantiques contenues dans les régions 103a de la couche 103 ont conservé leurs propriétés photoluminescentes initiales.

La figure 1D illustre une étape postérieure à l'étape de développement de la figure 1C, au cours de laquelle on retire les régions subsistantes 105a de la couche de résine 105, sans avoir retiré au préalable et sans retirer simultanément les régions 103b de la couche 103. En d'autres termes, le retrait des régions subsistantes 105a de la couche de résine 105 est un retrait sélectif par rapport à la résine de la couche 103. A titre d'exemple, le retrait des régions 105a de la couche de résine 105 est réalisé par gravure sèche à l'aide d'un plasma oxygène.

Les mesures réalisées montrent qu'après le retrait des régions 105a de la couche 105, les boîtes quantiques contenues dans les régions 103a de la couche 103 sont toujours actives, et les boîtes quantiques contenues dans les régions 103b de la couche 103 sont toujours inactives.

Ainsi, le procédé proposé permet d'obtenir une couche 103 d'épaisseur sensiblement constante contenant des boîtes quantiques, cette couche comportant des premières régions 103a dans lesquelles les boîtes quantiques sont actives, et des deuxièmes régions 103b dans lesquelles les boîtes quantiques sont inactives.

Après l'étape de retrait des régions 105a de la couche 105, une étape supplémentaire de gravure physique d'une portion superficielle supérieure de la couche 103, par exemple à l'aide d'un plasma d'oxygène et d'hexafluorure de soufre (SF₆), peut être mise en oeuvre. Cette étape supplémentaire de gravure permet d'accentuer le contraste du motif photoluminescent défini dans la couche 103.

Lors d'une étape ultérieure, la couche 103 dans laquelle est formé le motif photoluminescent peut par exemple être rapportée en regard d'un dispositif d'éclairage, par exemple une matrice de diodes électroluminescentes, puis le substrat de support 101 peut être retiré. A titre de variante, le substrat de support 101 peut être en un matériau transparent, par exemple du verre, auquel cas l'ensemble comportant le substrat de support 101 et la couche 103 peut être disposé en regard du dispositif d'éclairage. A titre de variante, le substrat de support 101 peut être directement un substrat semiconducteur dans lequel ont été préalablement formées des diodes électroluminescentes, la couche 103 étant alors formée directement au-dessus des diodes électroluminescentes.

Un avantage du procédé proposé réside notamment dans le fait que la couche de conversion de couleur 103 obtenue présente une épaisseur constante ou quasi-constante, ce qui lui procure une robustesse relativement élevée, et rend plus aisé l'assemblage avec un éventuel élément optique supplémentaire.

Un autre avantage du procédé proposé réside dans le fait que la couche de boîtes quantiques 103, de par sa morphologie et sa stabilité, est compatible avec les techniques de report, collage et alignement standard en microélectronique.

Un autre avantage du procédé proposé est lié au fait que l'incorporation des boîtes quantiques dans une couche de résine permet d'obtenir une couche 103 relativement épaisse, ce qui est tout particulièrement adapté pour les applications de conversion de couleur dans des écrans d'affichage lumineux.

Un autre avantage du procédé proposé est que les motifs photoluminescents peuvent être définis dans la couche 103 avec une résolution relativement élevée. A titre d'exemple illustratif, le procédé proposé permet de définir dans la couche 103 des plots photoluminescents présentant des dimensions latérales de l'ordre de 1 à 10 µm et un espacement de l'ordre de 1 à 10 µm, ce qui est compatible avec la réalisation d'un écran d'affichage lumineux à base de diodes électroluminescentes.

La figure 2 est une vue en coupe illustrant de façon schématique une variante de réalisation du procédé décrit en relation avec les figures 1A à 1D.

Dans l'exemple de la figure 2, le procédé décrit en relation avec les figures 1A à 1D est répété une deuxième fois de façon à former, sur la surface supérieure de la couche 103, une couche de résine 103' dans laquelle sont incorporées des boîtes quantiques, cette couche comportant des régions 103a' dans lesquelles les boîtes quantiques sont actives, et des régions 103b' dans lesquelles les boîtes quantiques sont inactives.

A titre d'exemple, les boîtes quantiques actives de la couche 103 sont adaptées à convertir la lumière d'une source lumineuse d'excitation en une lumière d'une première couleur, par exemple en lumière rouge, et les boîtes quantiques actives de la couche 103' sont adaptées à convertir la lumière de la source lumineuse d'excitation en une lumière d'une deuxième couleur différente de la première couleur, par exemple en lumière verte. Les boîtes quantiques de la couche 103' sont par exemple de même nature que les boîtes quantiques de la couche 103, mais de dimensions différentes.

Les régions actives 103a' de la couche 103' sont par exemple disposées en regard de régions inactives 103b de la couche 103. Bien que cela ne soit pas visible sur la figure 2, des régions inactives 103b' de la couche 103' peuvent être disposées en regard de régions inactives 103b de la couche 103, de façon à transmettre sans modification de couleur significative la lumière émise par la source lumineuse.

Des modes de réalisation particuliers ont été décrits. Diverses variantes et modifications apparaîtront à l'homme de l'art. En particulier, les modes de réalisation décrits ne se limitent pas aux exemples particuliers de dimensions et de matériaux susmentionnés.

De plus, bien que l'on ait décrit ci-dessus un exemple de procédé dans lequel la matrice de la couche 103 est une résine photosensible négative et la résine de la couche 105 est une résine photosensible positive, les deux types de résine peuvent être intervertis, c'est-à-dire que la matrice de la couche 103 peut être choisie parmi la famille des résines photosensibles positives, la résine de la couche 105 étant alors choisie parmi la famille des résines photosensibles négatives.

Plus généralement, la matrice de la couche 103 peut être en un matériau autre qu'une résine photosensible, par exemple une résine non photosensible, du silicone, ou tout autre matériau polymère adapté.

En outre, les modes de réalisation décrits ne se limitent pas à l'exemple particulier susmentionné d'application à la conversion de couleur dans un écran d'affichage lumineux. Plus généralement, le procédé proposé permettant de délimiter des zones actives et des zones inactives dans une couche d'une matrice incorporant des boîtes quantiques pourra être utilisé dans d'autres domaines.

## Revendications

1. Procédé de fabrication d'une couche (103) contenant des boîtes quantiques, cette couche comportant des premières régions (103a) dans lesquelles les boîtes quantiques sont actives, et des deuxièmes régions (103b) dans lesquelles les boîtes quantiques sont inactives, ce procédé comportant les étapes suivantes :
a) déposer sur un support (101) une première couche (103) d'une matrice dans laquelle sont incorporées des boîtes quantiques ;
b) déposer sur la première couche (103) une deuxième couche (105) de résine photosensible ;
c) insoler la deuxième couche (105) au travers d'un masque (107) délimitant, en vue de dessus, les premières (103a) et deuxièmes (103b) régions, puis développer la résine de la deuxième couche (105) de façon à retirer la résine de la deuxième couche (105) en regard des deuxièmes régions (103b), et à conserver la résine de la deuxième couche (105) en regard des premières régions (103a) ; et
d) retirer la résine de la deuxième couche (105) en regard des premières régions (103a) sans retirer la matrice de la première couche (103) en regard des premières (103a) et deuxièmes (103b) régions.

2. Procédé selon la revendication 1, dans lequel la matrice de la première couche (103) est une résine photosensible.

3. Procédé selon la revendication 2, dans lequel la résine photosensible de la première couche (103) est choisie parmi l'une des familles de l'ensemble comportant la famille des résines photosensibles positives et la famille des résines photosensibles négatives, et dans lequel la résine photosensible de la deuxième couche (105) est choisie parmi l'autre famille dudit ensemble.

4. Procédé selon l'une quelconque des revendications 1 à 3, dans lequel la matrice de la première couche (103) est une résine photosensible négative et dans lequel la résine de la deuxième couche (105) est une résine photosensible positive.

5. Procédé selon l'une quelconque des revendications 1 à 4, dans lequel la matrice de la première couche (103) est une résine photosensible de type SU8, et dans lequel la résine de la deuxième couche (105) est une résine de type TELR.

6. Procédé selon l'une quelconque des revendications 1 à 5, ne comportant pas d'étape d'insolation de la matrice de la première couche (103) avant le dépôt de la deuxième couche (105).

7. Procédé selon l'une quelconque des revendications 1 à 6, dans lequel l'étape de développement de la résine de la deuxième couche (105) comprend le trempage de la deuxième couche (105) dans une solution à base de TMAH.

8. Procédé selon l'une quelconque des revendications 1 à 7, dans lequel les boîtes quantiques incorporées dans la matrice de la première couche (103) sont des boîtes quantiques de type CdSe/ZnS.

9. Procédé selon l'une quelconque des revendications 1 à 8, dans lequel, lors de l'étape d), la résine de la deuxième couche (105) est retirée par gravure plasma à l'oxygène.

10. Procédé selon l'une quelconque des revendications 1 à 9, comportant en outre, après l'étape d), une étape de gravure d'une portion superficielle supérieure de la première couche (103) .

11. Procédé selon la revendication 9, dans lequel ladite étape de gravure d'une portion superficielle supérieure de la première couche (103) est réalisée par gravure plasma à l'oxygène et à l'hexafluorure de soufre.

12. Procédé selon l'une quelconque des revendications 1 à 11, dans lequel les étapes a), b), c) et d) sont répétées une deuxième fois pour former, sur la première couche (103), une troisième couche (103') contenant des boîtes quantiques, cette troisième couche comportant des premières régions (103a') dans lesquelles les boîtes quantiques sont actives, et des deuxièmes régions (103b') dans lesquelles les boîtes quantiques sont inactives.

13. Procédé selon la revendication 12, dans lequel les premières régions (103a') de la troisième couche (103') sont disposées en regard de deuxièmes régions (103b) de la première couche (103), et dans lequel des deuxièmes régions (103b') de la troisième couche (103') sont disposées en regard de premières régions (103a) de la première couche (103).

## Patentansprüche

1. Verfahren zur Herstellung einer Schicht (103), die Quantenpunkte enthält, wobei die Schicht erste Bereiche (103a) aufweist, in denen die Quantenpunkte aktiv sind, und zweite Bereiche (103b), in denen die Quantenpunkte inaktiv sind, wobei das Verfahren die folgenden Schritte aufweist:
a) Abscheiden einer ersten Schicht (103) einer Matrix mit in sie eingebauten Quantenpunkten auf einem Träger (101);
b) Abscheiden einer zweiten Resistschicht (105) auf der ersten Schicht (103);
c) Belichten der zweiten Schicht (105) mit Licht durch eine Maske (107), die in der Draufsicht die ersten (103a) und zweiten (103b) Bereiche begrenzt, und dann Entwickeln des Harzes der zweiten Schicht (105), um das Harz der zweiten Schicht (105) gegenüber den zweiten Bereichen (103b) zu entfernen und das Harz der zweiten Schicht (105) gegenüber den ersten Bereichen (103a) zu erhalten; und
d) Entfernen des Harzes der zweiten Schicht (105) gegenüber den ersten Bereichen (103a), ohne die Matrix der ersten Schicht (103) gegenüber dem ersten (103a) und zweiten (103b) Bereich zu entfernen.

2. Verfahren nach Anspruch 1, wobei die Matrix der ersten Schicht (103) ein Resist ist.

3. Verfahren nach Anspruch 2, wobei der Resist der ersten Schicht (103) ausgewählt ist aus einer der Familien der Gruppe, die die Familie der positiven Resists und die Familie der negativen Resists aufweist, und wobei der Resist der zweiten Schicht (105) aus der anderen Familie der Gruppe ausgewählt ist.

4. Verfahren nach einem der Ansprüche 1 bis 3, wobei die Matrix der ersten Schicht (103) ein negativer Resist ist und wobei das Harz der zweiten Schicht (105) ein positiver Resist ist.

5. Verfahren nach einem der Ansprüche 1 bis 4, wobei die Matrix der ersten Schicht (103) ein Resist vom SU8-Typ ist, und wobei das Harz der zweiten Schicht (105) ein Resist vom TELR-Typ ist.

6. Verfahren nach einem der Ansprüche 1 bis 5, das keinen Schritt der Belichtung der Matrix der ersten Schicht (103) vor dem Abscheiden der zweiten Schicht (105) aufweist.

7. Verfahren nach einem der Ansprüche 1 bis 6, wobei der Schritt des Entwickelns des Harzes der zweiten Schicht (105) das Eintauchen der zweiten Schicht (105) in eine TMAH-basierte Lösung aufweist.

8. Verfahren nach einem der Ansprüche 1 bis 7, wobei die in die Matrix der ersten Schicht (103) eingearbeiteten Quantenpunkte Quantenpunkte vom Typ CdSe/ZnS sind.

9. Verfahren nach einem der Ansprüche 1 bis 8, wobei bei Schritt d) das Harz der zweiten Schicht (105) durch Sauerstoffplasmaätzen entfernt wird.

10. Verfahren nach einem der Ansprüche 1 bis 9, das ferner nach Schritt d), einen Schritt des Ätzens eines oberen Oberflächenabschnitts der ersten Schicht (103) aufweist.

11. Verfahren nach Anspruch 9, wobei der Schritt des Ätzens eines oberen Oberflächenabschnitts der ersten Schicht (103) durch Sauerstoff- und Schwefelhexafluorid-Plasmaätzen durchgeführt wird.

12. Verfahren nach einem der Ansprüche 1 bis 11, wobei die Schritte a), b), c) und d) ein zweites Mal wiederholt werden, um auf der ersten Schicht (103) eine dritte Schicht zu bilden, die Quantenpunkte enthält, wobei die dritte Schicht (103') erste Bereiche (103a') aufweist, in denen die Quantenpunkte aktiv sind, und zweite Bereiche (103b'), in denen die Quantenpunkte inaktiv sind.

13. Verfahren nach Anspruch 12, wobei die ersten Bereiche (103a') der dritten Schicht (103') gegenüber den zweiten Bereichen (103b) der ersten Schicht (103) angeordnet sind, und wobei die zweiten Bereiche (103b') der dritten Schicht (103') gegenüber den ersten Bereichen (103a) der ersten Schicht (103) angeordnet sind.

## Claims

1. A method of manufacturing a layer (103) containing quantum dots, the layer comprising first regions (103a) where the quantum dots are active, and second regions (103b) where the quantum dots are inactive, the method comprising the steps of:
a) depositing on a support (101) a first layer (103) of a matrix having quantum dots incorporated into it;
b) depositing on the first layer (103) a second resist layer (105);
c) exposing the second layer (105) to light through a mask (107) delimiting, in top view, the first (103a) and second (103b) regions, and then developing the resin of the second layer (105) in order to remove the resin of the second layer (105) opposite the second regions (103b), and to keep the resin of the second layer (105) opposite the first regions (103a); and
d) removing the resin of the second layer (105) opposite the first regions (103a) without removing the matrix of the first layer (103) opposite the first (103a) and second (103b) regions.

2. The method of claim 1, wherein the matrix of the first layer (103) is a resist.

3. The method of claim 2, wherein the resist of the first layer (103) is selected from one of the families of the assembly comprising the family of positive resists and the family of negative resists, and wherein the resist of the second layer (105) is selected from the other family of said assembly.

4. The method of any of claims 1 to 3, wherein the matrix of the first layer (103) is a negative resist and wherein the resin of the second layer (105) is a positive resist.

5. The method of any of claims 1 to 4, wherein the matrix of the first layer (103) is a SU8-type resist, and wherein the resin of the second layer (105) is a TELR-type resist.

6. The method of any of claims 1 to 5, comprising no step of exposure to light of the matrix of the first layer (103) before the deposition of the second layer (105).

7. The method of any of claims 1 to 6, wherein the step of developing the resin of the second layer (105) comprises dipping the second layer (105) into a TMAH-based solution.

8. The method of any of claims 1 to 7, wherein the quantum dots incorporated in the matrix of the first layer (103) are quantum dots of CdSe/ZnS type.

9. The method of any of claims 1 to 8, wherein, at step d), the resin of the second layer (105) is removed by oxygen plasma etching.

10. The method of any of claims 1 to 9, further comprising, after step d), a step of etching an upper surface portion of the first layer (103).

11. The method of claim 9, wherein said step of etching an upper surface portion of the first layer (103) is carried out by oxygen and sulfur hexafluoride plasma etching.

12. The method of any of claims 1 to 11, wherein steps a), b), c), and d) are repeated a second time to form, on the first layer (103), a third layer containing quantum dots, the third layer (103') comprising first regions (103a') where the quantum dots are active, and second regions (103b') where the quantum dots are inactive.

13. The method of claim 12, wherein the first regions (103a') of the third layer (103') are arranged opposite second regions (103b) of the first layer (103), and wherein second regions (103b') of the third layer (103') are arranged opposite first regions (103a) of the first layer (103).
